# EUROPEAN PATENT SPECIFICATION

(11) **EP 3 576 147 B1**
(45) Date of publication and mention of the grant of the patent: **06.04.2022**
(21) Application number: 19159803.6
(22) Date of filing: 27.02.2019
(51) Int. Cl.: H01L 25/075, H01L 33/58, F21S 8/08, F21Y 105/16, F21W 131/103, F21V 17/00, F21V 5/00, F21V 5/08, F21V 17/16, F21Y 105/10

(54) **LIGHT EMITTING DEVICE MODULE**
LICHTEMITTIERENDES VORRICHTUNGSMODUL
MODULE DE DISPOSITIF ÉLECTROLUMINESCENT

(30) Priority: 30.05.2018 CN 201810538111
(43) Date of publication of application: 04.12.2019
(73) Proprietor: Seoul Semiconductor Co., Ltd., Gyeonggi-do (KR)
(72) Inventor: Zhang, MingJun, Ansan-si, Gyeonggi-do (KR); Zhang, Zhisheng, Ansan-si, Gyeonggi-do (KR)
(74) Representative: Stolmár & Partner Patentanwälte PartG mbB

(56) References cited:
- DE-U1-202013 010 052
- US-A- 4 941 072
- US-A1- 2009 310 356
- US-A1- 2011 085 329

## Description

### BACKGROUND

### 1. Field of disclosure

The present disclosure relates to a light emitting device module. More particularly, the present disclosure relates to a light emitting device module used as an exterior lighting.

### 2. Description of the Related Art

A light emitting diode is a semiconductor light emitting device that emits a light due to an electric potential difference when electrons and holes are recombined with each other in a P-N semiconductor junction structure by a current applied thereto. The light emitting device employing the light emitting diode has advantages, such as eco-friendly property, low voltage operation, long lift-span, and low price.

The light emitting diode has conventionally been widely applied to simple information displays such as display lamps and a number display, however, in recent years, the light emitting diode is being used in a variety of fields, such as display field, lighting field, car head lamp, or projector, with the development of industrial technology, especially the development of information display technology and semiconductor technology. In particular, the light emitting diode is being applied to external fixtures, such as a street light and a traffic light. Accordingly, when the light emitting diode is used in the external fixtures exposed to relatively harsh environments, the light emitting diode is required to have a more durable structure.

US 2009/0310356 A1 discloses a lamp device with a lens holder having a plurality of windows for holding a plurality of lenses, each of the lenses having an alignment protrusion interacting with an alignment notch in the lens holder, the alignment notch and the alignment protrusion defining the orientation of the lens.

DE 20 2013 010 052 U1 discloses a lamp device with a substrate holding a plurality of LEDs, a plurality of lenses, and a grid element for holding the plurality of lenses, the lenses comprising positioning elements for positioning the lenses with respect to the substrate.

The US 2011/0085329 A1 discloses a lens module with a frame having a plurality of windows for holding individual lenses, and a plurality of lenses, the lenses having engaging structures for positioning and holding the lenses in the frame.

The US 4,941,072 discloses a lighting device with a longitudinal array of LEDs, a longitudinal lens, and a lens holder, the lens holder having a slot for receiving a coupling feature of the lens by snap-fit.

### SUMMARY

The present disclosure provides a light emitting device module according to claim 1 that is easily attachable and detachable.

Embodiments of the inventive concept provide a light emitting device module including a substrate including a plurality of light emitting areas, a light emitting device disposed in each light emitting area to emit a light, windows disposed on the substrate, each of the windows covering each light emitting area, and having an asymmetrical shape with respect to a line passing through the center of the window, and a holder to hold the windows, the holder being provided with openings, each of which is defined therethrough in an asymmetrical shape corresponding to the each window in the light emitting areas. Each of the windows is individually provided in a corresponding opening among the opening and detachably coupled to the holder.

Each of the windows is individually provided in the opening along a direction to anisotropically control an advance direction of the light and detachably coupled to the holder.

Each of the window and the holder includes an insertion member that determines a coupling direction when the each window and the holder are coupled to each other, and the insertion member has an asymmetrical shape with respect to the line passing through the center of the window.

The window further includes an insertion protrusion protruded toward the holder, and the holder further includes an insertion recess into which the insertion protrusion is inserted.

The insertion protrusion includes a first insertion protrusion and a second insertion protrusion, which are respectively disposed at both sides of the each window, and the first and second insertion protrusions have different lengths from each other.

The insertion recess comprises a first insertion recess and a second insertion recess, the insertion recesses corresponding to the first and second insertion protrusions have different lengths from each other.

The light emitted from the light emitting device has an anisotropy, and protruding directions of the first and second insertion protrusions correspond to the anisotropy of the light, so as to align the window such that the light is emitted in a predetermined direction in response to the anisotropy of the light.

The protruding directions of the first and second insertion protrusions of the each window disposed in each light emitting area are same as each other.

Optionally, the holder includes a holder coupling protrusion protruded toward the each window, the each window includes a window coupling protrusion protruded toward the holder, and the holder coupling protrusion and the window coupling protrusion are engaged with each other.

The holder further may include a slot recessed from a surface of the holder and defined adjacent to the holder coupling protrusion.

The slot may have a width that decreases as a distance from the surface increases.

Optionally, the window further includes a supporting protrusion protruded toward the holder, and the holder then includes a supporting recess corresponding to the supporting protrusion to stop movement of the window in a predetermined direction beyond a certain distance.

The each window may include a lens part disposed to correspond to the light emitting area and having a curved surface and a flat part disposed around the lens part and substantially parallel to a surface of the substrate.

The lens parts respectively disposed in the light emitting areas may have a same shape as each other or different shapes from each other.

The each window may change the light emitted from the light emitting device in a predetermined direction.

A ratio of a width to a length of the holder can be about 1 : 0.8 to about 1 : 1.25, and a ratio of a width to a length of the window about 1 : 0.5 to about 1 : 1.3.

The light emitting device module according to an exemplary embodiment of the present disclosure may be employed in a street light, and the street light according to an exemplary embodiment of the present disclosure may include a pole extending in one direction, an arm connected to one side portion of the pole, and a light emitting device module disposed at one end portion of the arm.

According to the above, the light emitting device module may be easily attached and detached.

### BRIEF DESCRIPTION OF THE DRAWINGS

The above and other advantages of the present disclosure will become readily apparent by reference to the following detailed description when considered in conjunction with the accompanying drawings wherein:
FIG. 1 is a perspective view showing a light emitting device module according to an exemplary embodiment of the present disclosure;
FIG. 2 is an exploded perspective view showing the light emitting device module of FIG. 1;
FIG. 3 is a plan view showing a window unit including a holder provided with an opening defined therethrough and a window coupled to the opening of the holder;
FIGS 4A, 4B, and 4C are cross-sectional views respectively taken along lines A-A', B-B', and C-C' of FIG. 3;
FIG. 5 is a perspective view showing a coupling process of the window to the holder in the window unit of the light emitting device module according to an exemplary embodiment of the present disclosure;
FIGS. 6A, 6B, and 6C are cross-sectional views sequentially showing processes for coupling the window to the holder;
FIG. 7 is an enlarged view showing a portion P1 of FIG. 6B; and
FIG. 8 is a side view showing a street light according to an exemplary embodiment of the present disclosure.

### DETAILED DESCRIPTION

The present disclosure may be variously modified and realized in many different forms, and thus specific embodiments will be exemplified in the drawings and described in detail hereinbelow. However, the present invention should not be limited to the specific disclosed forms, and be construed to include all modifications, equivalents, or replacements included in the scope of the invention defined in the attached claims.

Hereinafter, exemplary embodiments of the present disclosure will be explained in detail with reference to the accompanying drawings.

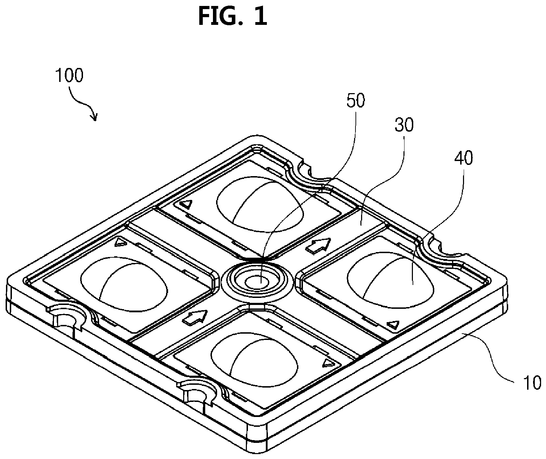

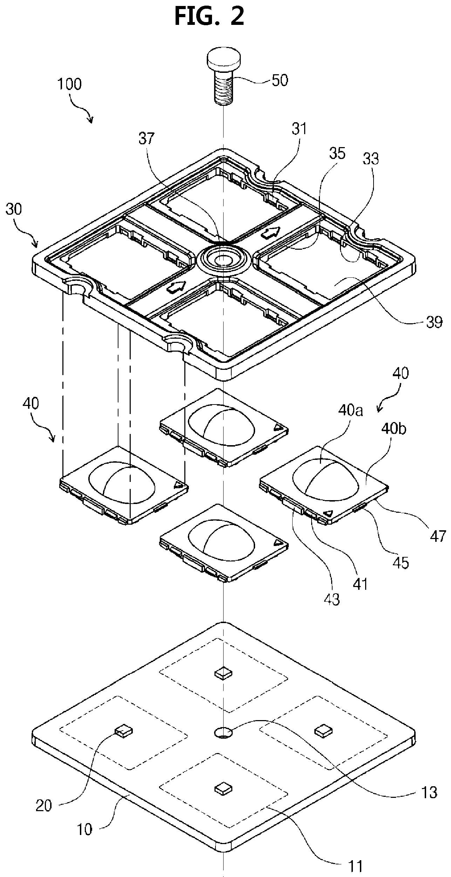

FIG. 1 is a perspective view showing a light emitting device module according to an exemplary embodiment of the present disclosure, and FIG. 2 is an exploded perspective view showing the light emitting device module of FIG. 1.

Referring to FIGS. 1 and 2, the light emitting device module 100 according to an exemplary embodiment of the present disclosure includes a substrate 10, a light emitting device 20 disposed on the substrate 10, and a window unit covering the substrate 10 and the light emitting device 20.

The substrate 10 is provided for mounting a plurality of light emitting devices 20 thereon. The substrate 10 includes , in accordance with the invention, one or more light emitting areas 11 defined therein, in which the light emitting device 20 is disposed to emit a light, and one or more light emitting devices 20 are disposed in every light emitting area 11.

In the exemplary embodiment of the present disclosure, a plurality of light emitting areas 11 is, in accordance with the invention, defined on the substrate 10, and a size and a light amount of the light emitting device module 100 may be determined by the number of the light emitting areas 11 . For example, the light emitting areas 11 may be arranged in two-by-two (2×2) matrix form, however this is merely exemplary. As another example, the light emitting areas 11 may be arranged in various ways, e.g., three-by-four (3×4) or two-by-six (2×6) matrix form.

The substrate 10 may have a variety of shapes. For example, the substrate 10 may have a quadrangular shape when viewed in a plan view and may be provided in a plate shape with a predetermined height, however, the shape of the substrate 10 should not be limited thereto or thereby. That is, the substrate 10 may have an oval or circular shape.

The substrate 10 includes a wiring and a terminal to supply a power to the light emitting device 20. In the exemplary embodiment of the present disclosure, the substrate 10 may be a printed circuit board. However, the substrate 10 should not be limited thereto or thereby and may include various materials and shapes.

For example, at least a portion of the substrate 10 may include a material having high thermal conductivity. The substrate 10 may include a metal material, such as copper, iron, nickel, chromium, aluminum, silver, gold, titanium, and alloys thereof. As another example, the substrate 10 may include a non-conductive material, such as ceramic, polymer resin, glass, or composite materials thereof (for example, composite resin or mixture of composite resin and conductive material).

At least one light emitting device 20 is provided for each light emitting area 11 on the substrate 10. For example, one light emitting device 20 may be provided for each light emitting area 11.

In the exemplary embodiment of the present disclosure, the light emitting device 20 may emit the light in a direction to which an upper surface of the substrate 10 faces. For example, the light emitting device 20 may be disposed on the upper surface of the substrate 10 and may emit the light radially. In this case, the light emitting device 20 may emit the light uniformly and isotropically at all angles. However, the light emitting direction of the light emitting device 20 should not be limited thereto or thereby. For example, the light emitting direction of the light emitting device 20 may be limited to within a certain angle, and in this case, the light may be emitted anisotropically along a predetermined direction. Accordingly, in a case where a light with a directivity in a specific direction is required, a light emission in the specific direction may be easily realized by using the light emitting device 20 that emits the light anisotropically.

In the exemplary embodiment of the present disclosure, the light emitting device 20 may be implemented by a light emitting diode chip. Although not shown in figures, the light emitting device 20 may include a light emitting structure and an electrode part.

The light emitting structure may include a first semiconductor layer, an active layer, and a second semiconductor layer, which are sequentially provided.

The first semiconductor layer is a semiconductor layer doped with a first conductive type dopant. The first conductive type dopant may be an n-type dopant. The first conductive type dopant may be Si, Ge, Se, Te, or C. In the exemplary embodiment of the present disclosure, the first semiconductor layer may include a nitride-based semiconductor material. For example, the first semiconductor layer may include a semiconductor material represented by the following composition formula of InₓAl_{y}Ga_{1-x-y}N(0≤x≤1, 0≤y≤1, 0≤x+y≤1). The active layer is disposed on the first semiconductor layer and corresponds to a light emitting layer.

The active layer is a layer in which electrons (or holes) injected through the first conductive type semiconductor layer and holes (or electrons) injected through the second semiconductor layer are combined with each other to emit the light by a band gap difference of an energy band according to a material forming the active layer. The active layer may emit at least one peak wavelength of ultraviolet light, blue light, green light, and red light. The active layer may be implemented by a compound semiconductor. The active layer may be implemented by, for example, at least one element of compound III-V semiconductors or compound II-VI semiconductors and may be implemented by a material represented by the following composition formula of InₓAl_{y}Ga_{1-x-y}N(0≤x≤1, 0≤y≤1, 0≤x+y≤1).

The second semiconductor layer is disposed on the active layer. The second semiconductor layer is a semiconductor layer doped with a second conductive type dopant having a polarity opposite to that of the first conductive type dopant. The second conductive type dopant may be a p-type dopant and may include Mg, Zn, Ca, Sr, or Ba. In the exemplary embodiment of the present disclosure, the second semiconductor layer may include a nitride-based semiconductor material. For example, the second semiconductor layer may include a semiconductor material represented by the following composition formula of InₓAl_{y}Ga_{1-x-y}N(0≤x≤1, 0≤y≤1, 0≤x+y≤1).

In the exemplary embodiment of the present disclosure, a cathode and an anode are respectively disposed on the first semiconductor layer and the second semiconductor layer and connected to the first semiconductor layer and the second semiconductor layer, and the cathode and the anode are connected to the wiring or the terminal to receive the power.

Referring to FIGS. 1 and 2, the window unit is disposed on the substrate 10 and covers the light emitting area 11 and a remaining portion of the substrate 10 except for the light emitting area 11. That is, the window unit may cover substantially most of the substrate 10 when viewed in a plan view. However, the window unit may be partially disposed on a portion of the upper surface of the substrate 10 so that the upper surface of the substrate 10 may be partially exposed.

The window unit includes a window 40 transmitting the light from the light emitting device 20 and a holder 30 holding the window 40.

The holder 30 is disposed on the substrate 10 and has a frame shape for holding the window 40. Accordingly, the holder 30 may correspond to the remaining portion of the substrate 10 except for the light emitting area 11. An opening 39 is defined through portions respectively corresponding to the light emitting areas 11, and the window 40 is disposed in the opening 39.

The opening 39 may have various shapes depending on the shape of the window 40. For example, in a case where the window 40 has a quadrangular shape, the opening 39 may have the quadrangular shape corresponding to the shape of the window 40. As another example, in a case where the window 40 has an oval shape, the opening 39 may have the oval shape corresponding to the shape of the window 40.

The holder 30 may have various shapes depending on a size of the substrate 10 and the number of the light emitting areas 11 defined in the substrate 10. The holder 30 includes components for stably holding and supporting the window 40, and details thereof will be described later.

The window 40 is disposed on each light emitting area 11 in a one-to-one correspondence and covers a corresponding light emitting area. The window 40 may protect the light emitting device 20 and substantially simultaneously may act as an optical component for transmitting the light emitted from the light emitting device 20 or guiding the light emitted from the light emitting device 20 to a predetermined direction.

The window 40 may have various shapes when viewed in a plan view. For example, the window 40 may have a rectangular shape, however the shape of the window 40 should not be limited to the rectangular shape. That is, the window 40 may have a polygonal shape or an oval shape.

In the exemplary embodiment of the present disclosure, the shape of the window 40 has, and the shape of the opening 39 of the holder 30 corresponding to the window 40 may have an asymmetrical shape with respect to a predetermined direction. According to the invention, the window 40 may have a shape where both sides thereof are asymmetric with respect to a line passing through a center of the window 40. For instance, the shape of the window 40 may be changed in various ways depending on the directivity of the light in the light emitting device module 100.

The window 40 may correspond to the shape of the light emitting area 11 and may include a lens part 40a of which at least a portion has a curved shape and a flat part 40b disposed around the lens part 40a and having an upper surface substantially parallel to the surface of the substrate 10.

The lens part 40a may have an oval shape protruding in an upward direction. The flat part 40b may have a plate shape substantially parallel to the upper surface of the substrate 10 disposed thereunder and may be disposed around the lens part 40a. However, the shape of the lens part 40a should not be limited thereto or thereby, and the lens part 40a may have other shapes depending on a light emitting efficiency and a light emitting direction.

In addition, the upper surface of the flat part 40b may be substantially parallel to the upper surface of the substrate 10, however, this is merely exemplary. That is, a portion of a lower surface of the flat part 40b may be parallel and the other portion of the lower surface of the flat part 40b may be slant to facilitate coupling with other components. In the exemplary embodiment of the present disclosure, the lens part 40a and the flat part 40b may be integrally formed with each other without being separated from each other.

The lens part 40a may have various shapes to change a path of the traveling light in response to a profile of the light emitted from the light emitting device 20.

Depending on the application in which the light emitting device module 100 according to the exemplary embodiment of the present disclosure is used, a light condensation or dispersion may be required, and thus the lens part 40a may have various shapes different from each other. For example, the lens part 40a may have a plate shape, a convex lens shape, or a concave lens shape. Further, the lens part 40a may have various shapes, such as a spherical shape, an ovoidal shape, a hemispherical shape, a half-oval spherical shape, or a bifocal shape.

The lens part 40a may include a transparent insulating material to transmit the light from the light emitting device 20. The lens part 40a may protect the light emitting device 20 and may substantially simultaneously transmit the light emitted from the light emitting device 20.

In addition, the lens part 40a may include a material that is not deformed or discolored by the light emitted from the light emitting device 20. For example, in a case where the light emitted from the light emitting device 20 is an ultraviolet light, the lens part 40a may include a material that is not deformed or discolored by the ultraviolet light.

The lens part 40a may include various materials that satisfy the above-mentioned functions, however it should not be particularly limited. For example, the lens part 40a may include quartz or polymer organic material. In the case where the lens part 40a includes the polymer organic material, since a wavelength of the light absorbed/transmitted by the polymer organic material is different depending on a type of monomers, a molding method using the monomers, and conditions for forming the polymer by the monomers, the polymer organic material may be selected among various kinds of polymer organic materials by taking into account the wavelength of the light emitted from the light emitting device 20. For example, an organic polymer, such as poly(methylmethacrylate) (PMMA), polyvinylalcohol (PVA), polypropylene (PP), and low density polyethylene (PE), hardly absorbs the ultraviolet light, and an organic polymer such as polyester may absorb the ultraviolet light.

In the exemplary embodiment of the present disclosure, each window 40 is individually detachably coupled to each opening 39 of the holder 30.

The window 40 includes a window coupling protrusion 41 for coupling to the holder 30, and the holder 30 includes a holder coupling protrusion 31 corresponding to the window coupling protrusion 41.

The holder 30 may include a supporting recess 33 defined therein to allow the window 40 to be stably coupled to a specific position of the holder 30 without moving too far beyond a predetermined distance when the holder 30 is coupled to the window 40.

According to the invention, each of the holder 30 and the window 40 includes a component used to allow the window 40 to be coupled in a predetermined direction. The window 40 includes an insertion protrusion 45 protruding to the holder 30 so that the window 40 is easily coupled to the holder 30 in a light emitting direction. Correspondingly, the holder 30 includes an insertion recess 35 into which the insertion protrusion 45 is inserted. The insertion protrusion 45 and the insertion recess 35 are provided to be engaged with each other, and thus the window 40 may be easily coupled to the holder 30 without misalignment, such as about 90 or 180 degrees of window rotation, or overturning.

In the exemplary embodiment of the present disclosure, each of the window coupling protrusion 41, a supporting protrusion 43, and the insertion protrusion 45 may be provided in plural number and the position of each of the window coupling protrusion 41, a supporting protrusion 43, and the insertion protrusion 45 may be changed according to the embodiments. For example, the window coupling protrusion 41 may be provided in two pairs, and the window coupling protrusions 41 may be disposed at sides facing each other. The supporting protrusions 43 may be disposed between the window coupling protrusions 41 adjacent to each other. In addition, the insertion protrusions 45 may be disposed asymmetrically at two sides on which the window coupling protrusions 41 are not disposed. However, the number and positions of the window coupling protrusions 41, the supporting protrusions 43, and the insertion protrusions 45 should not be limited thereto or thereby, and may be changed in various ways as needed.

The window 40 may include a spacer 47 so as to be spaced apart from the substrate 10 by a predetermined distance when being coupled to the substrate 10.

The window unit and the substrate 10 are entirely connected to each other by a main coupling member 50. The main coupling member 50 is used to couple the window unit to the substrate 10 and should not be particularly limited.

In the exemplary embodiment of the present disclosure, the main coupling member 50 may be a screw, a holder hole 37 into which the screw is inserted may be formed in the holder 30 of the window unit, and a substrate hole 13 into which the screw is inserted may be formed in the substrate 10. The holder hole 37 and the substrate hole 13 may be located to overlap with each other when viewed in a plan view and may have different diameters from each other or the same diameter as each other. In addition, a screw thread may or may not be provided on the holder hole 37 and the substrate hole 13. Although not shown separately, when the screw thread is not provided on the holder hole 37 and the substrate hole 13, an additional component, such as a base plate coupled to the main coupling member 50, may be provided on a lower portion of the substrate 10. In this case, the main coupling member 50 may be screw-coupled to the base plate after passing through the holder hole 37 and the substrate hole 13. Accordingly, the substrate 10, the window unit, and the base plate may be securely coupled to each other using one screw.

Meanwhile, in FIGS. 1 and 2, grooves having a semicircular shape and disposed around the holder 30 when viewed in a plan view may be used for coupling with other components or may be omitted.

For the convenience of explanation, in the exemplary embodiment of the present disclosure, one window unit is disposed on one substrate, however, according to the present invention, two or more window units may be disposed on one substrate. For example, in the present exemplary embodiment, the window unit including the windows arranged in two-by-two matrix in one holder is disposed on the substrate having the light emitting areas arranged in two-by-two matrix. However, according to another embodiment of the present disclosure, two window units each including the windows arranged in two-by-two matrix in one holder may be disposed on the substrate having the light emitting areas arranged in two-by-four matrix. According to another embodiment of the present disclosure, two or more window units each including the windows arranged in matrices of different sizes may be disposed on one substrate. In the exemplary embodiment of the present disclosure, modules having various sizes may be formed through these various arrangements.

The light emitting device module according to the exemplary embodiment of the present disclosure may be easily repaired compared with a conventional light emitting device module. According to the conventional light emitting device module, a holder and a window are usually integrally formed with each other even though plural light emitting areas are provided, and as a result, when a defect occurs in one window, there is a problem that the entire window unit is required to be replaced at the same time. In contrast, the light emitting device module according to the exemplary embodiment of the present disclosure, since the plural windows are individually coupled to the holder to be detachable and attachable from and to the holder, only the window in which the defect occurs may be separated and replaced when the defects occurs in the light emitting device module, and thus the light emitting device module may be easily repaired.

In addition, according to the exemplary embodiment of the present disclosure, since the window may be attached and detached to and from the holder, the profile of the light emitted from the light emitting device module may be set in various ways, and the profile of the light may be easily changed by replacing a portion or all of the windows as needed. For example, considering directions of the light, the windows are disposed and coupled to the holder with the same direction as each other in accordance with the light emitting area, however, the windows in which the advance directions of the light are directed to different directions from each other may be disposed and coupled in accordance with the light emitting area, and thus the light may be emitted in various directions desired by a user. In the exemplary embodiment of the present disclosure, the advance directions of the light may be easily changed by using different light emitting devices or different lenses. In particular, the light may easily travel in a user's desired direction by changing the shape or curvature of the lens according to the light emitting area.

Further, since the light emitting device module according to the exemplary embodiment of the present disclosure includes the insertion protrusion and the insertion recess, the window may be coupled to the holder in a specific direction when being coupled to the holder. Therefore, the window may be prevented from being disposed in a wrong direction, for example, from being rotated about 90 or about 180 degrees, so as not to be aligned with a specific direction.

Hereinafter, the window unit including the holder and the attachable and detachable window will be described in detail with reference to accompanying drawings.

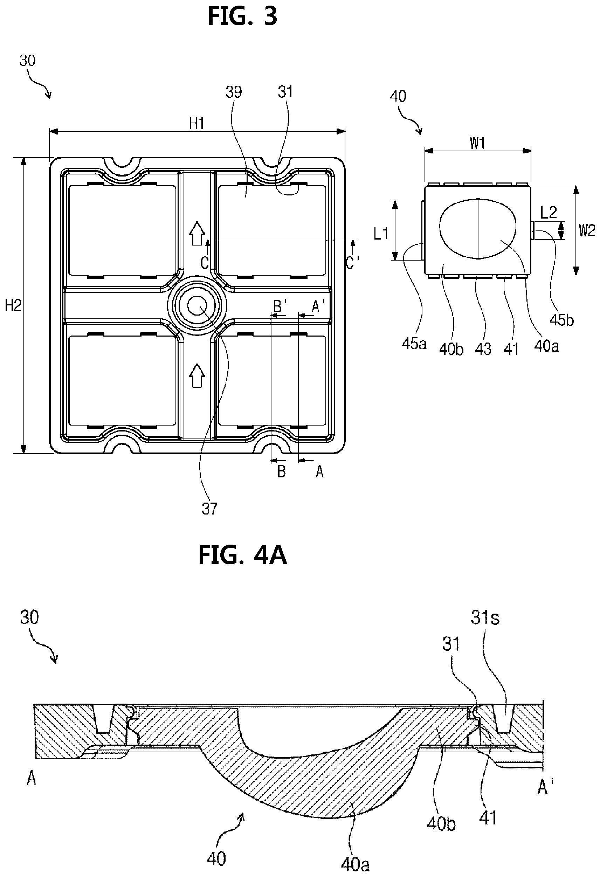

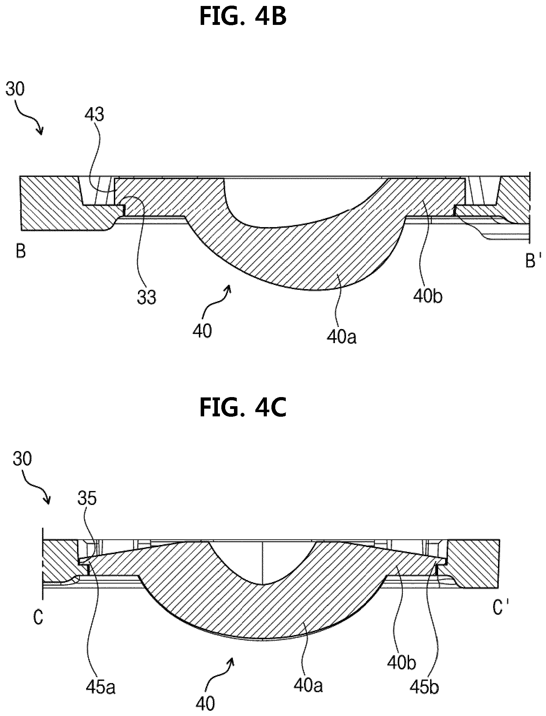

FIG. 3 is a plan view showing the window unit. In detail, FIG. 3 is a plan view showing the holder 30 provided with the opening 39 defined therethrough and one window 40 coupled to the opening 39 of the holder 30. FIGS 4A, 4B, and 4C are cross-sectional views respectively taken along lines A-A', B-B', and C-C' of FIG. 3.

For the convenience of explanation, the holder 30 and the window 40 are separately shown in FIG. 3, however, FIGS. 4A, 4B, and 4C show the cross-sections in which the window 40 is coupled to the holder 30. In addition, the window unit shown in FIG. 1 is upside down in FIGS. 4A, 4B, and 4C in consideration of the coupling process of the window 40 and the holder 30.

Referring to FIG. 3, the holder 30 may have substantially the same shape as that of the substrate 10. For example, the holder 30 may have a square shape as shown in FIG. 3, however, this is merely exemplary. The shape of the holder 30 according to the present disclosure should not be limited to the square shape.

For the convenience of explanation, when a horizontal direction is referred to as a "first direction" and a vertical direction is referred to as a "second direction", sides corresponding to the first and second directions correspond to a width H1 and a length H2 of the holder 30, respectively.

In the present exemplary embodiment, each of four openings 39 may have a predetermined width and a predetermined length.

The window 40 has a width W1 and a length W2, which respectively correspond to the width and the length of the opening 39, to allow the window 40 to be coupled to each opening 39 of the holder 30. For example, the width W1 and the length W2 of the window 40 are slightly smaller than the width and the length of the opening 39, respectively, and thus the window 40 may be easily inserted into corresponding opening 39. When the window 40 is inserted into the opening 39, the window 40 may be securely coupled to the holder 30 by the coupling members provided in the window 40 and the holder 30.

In the exemplary embodiment of the present disclosure, the width H1 and the length H2 of the holder 30 may be changed depending on the number and arrangements of the windows 40. For example, hereinafter, it is supposed that the holder 30 having the square shape with four openings 39 is provided as shown in FIG. 3.

In this case, the width H1 and the length H2 of the holder 30 may have a ratio of about 1 : 0.8 to about 1 : 1.25. In an exemplary embodiment, when the width H1 of the holder 30 is about 50mm, the length H2 of the holder 30 may be within a range from about 45mm to about 55mm. As another way, when the length H2 of the holder 30 is about 50mm, the width H1 of the holder 30 may be within a range from about 45mm to about 55mm. In the present exemplary embodiment, the width H1 and the length H2 of the holder 30 may be changed in various ways, and thus the width H1 of the holder 30 and the length H2 of the holder 30 may be changed appropriately within the range from about 45mm to about 55mm and may be matched with each other in an appropriate combination. In detail, the width H1 of the holder 30 may be about 50mm, and the length H2 of the holder 30 may be about 50mm.

The width W1 and the length W2 of the window 40 may be varied depending on the size of the holder 30, the number and arrangements of the windows 40, and the direction to which the light emitted from the light emitting device 20 is directed. For example, hereinafter, it is supposed that the window 40 corresponding to the holder 30 having the square shape with four openings 39 is provided as shown in FIG. 3.

In this case, the width W1 and the length W2 of the window 40 may have a ratio of about 1 : 0.5 to about 1 : 1.3. Particularly, in a case where the width H1 and the length H2 of the holder 30 are determined, the width W1 and the length W2 of the window 40 may be provided within a predetermined range when considering complexity of attachment and detachment structure and an irradiation angle of the light emitted from the light emitting device.

In an exemplary embodiment, when the width W1 of the window 40 is about 19mm, the length W2 of the window 40 may be within a range from about 15mm to about 23mm. As another way, when the length W2 of the window 40 is about 16mm, the width W1 of the window 40 may be within a range from about 12mm to about 20mm. In the present exemplary embodiment, the width W1 and the length W2 of the window 40 may be changed in various ways, and thus the width W1 of the window 40 may be changed appropriately within the range from about 15mm to about 23mm, the length W2 of the window 40 may be changed appropriately within the range from about 12mm to about 20mm, and the width W1 and the length W2 of the window 40 may be matched with each other in an appropriate combination. In detail, the width W1 of the window 40 may be about 19mm, and the length W2 of the window 40 may be about 16mm.

In the exemplary embodiment, when the width and the length of the holder 30 or the window 40 are within the above-mentioned range, a rigidity of the holder 30 or the window 40 may be maintained.

Referring to FIGS. 3, 4A, 4B, and 4C, the window 40 has a convex shape in one direction.

In an exemplary embodiment, the lens part 40a of the window 40 includes a first surface convexly protruded from a surface of the flat part 40b and a second surface opposite to the first surface. At least a portion of each of the first surface and the second surface may be a curved surface. For example, the entire lens part 40a may be formed of a curved surface as shown in figures.

The shape of the lens part 40a may be selected in various ways by taking into account the purpose of using the light emitting device module, the type of the light emitting device 20 used, the profile of the light from the light emitting device 20, and the profile of the light exiting through the lens part 40a.

The shape of the lens part 40a of the window 40 has an asymmetrical shape with respect to a line passing through a center of the window 40, e.g., the line B-B'. Particularly, the first and second surfaces of the lens part 40a may have different shapes from each other. As an example, each of the first and second surfaces of the lens part 40a may be asymmetrical with respect to a line passing through a center of the lens part 40a, and the first and second surfaces of the lens part 40a may have different curvatures from each other.

The first and second surfaces of the lens part 40a may be used to control the advance direction of the light emitted from the light emitting device 20 and may have various shapes. For example, although the light emitted from the light emitting device 20 is isotropic, the light passing through and exiting from the lens part 40a may have various profiles depending on the shape of the lens part 40a. On the contrary, in a case where the light emitted from the light emitting device 20 is anisotropic, the light passing through and exiting from the lens part 40a may have an isotropic profile by changing the shape of the lens part 40a.

In addition, in the exemplary embodiment of the present disclosure, since the lens part 40a has the second surface that is concave, the light emitted from the light emitting device 20 may effectively travel to the first surface. That is, the light emitting device 20 is disposed in the concave portion of the lens part 40a. Accordingly, even though a large amount of light is emitted through the side of the light emitting device 20, the light may travel as much as possible within the lens part 40a, and thus a light extraction efficiency may increase.

Referring to FIGS. 3 and 4A, the coupling protrusions are disposed in the window 40 and the holder 30 to couple the window 40 to the holder 30.

The window coupling protrusions 41 are disposed at both sides of the window 40 and protruded from the window 40 to the holder 30. The holder coupling protrusions 31 are protruded from the holder 30 facing the both sides of the window 40 to the window 40. The window coupling protrusion 41 and the holder coupling protrusion 31 are coupled to each other.

The holder 30 includes a slot 31s recessed from a surface of the holder 30 and defined adjacent to the holder coupling protrusion 31. When the slot 31s is defined in the holder 30, a space in which a portion where the holder coupling protrusion 31 is formed moves may be secured.

Referring to FIGS. 3 and 4B, members, which prevent the window 40 from being separated from the holder 30 again after passing the holder 30 when the window 40 is coupled to the holder 30, are provided to the window 40 and the holder 30. That is, the supporting recess 33 is defined in the holder 30 as a stopper to prevent the window 40 from passing through the holder 30 when the window 40 is coupled to the holder 30 while moving in one direction. The window 40 is provided with the supporting protrusion 43 that prevents the window 40 from moving further by being caught in the supporting recess 33 when the window 40 moves a predetermined distance in one direction. The supporting protrusion 43 is protruded from the window 40 to the holder 30, and the supporting recess 33 is formed in a shape to be engaged with the supporting protrusion 43 of the window 40.

Referring to FIGS. 3 and 4C, members, which determine a coupling direction of the window 40 when the window 40 is coupled to the holder 30, are provided to the window 40 and the holder 30. That is, in accordance with the invention, the insertion protrusion 45 is disposed on each window 40 to determine the coupling direction of the window 40 when the window 40 is coupled to the holder 30. The insertion protrusion 45 includes , according to the invention, first and second insertion protrusions 45a and 45b respectively disposed at both sides of the window 40. The insertion recesses 35 corresponding to the first and second insertion protrusions 45a and 45b are defined in the holder 30. In the present exemplary embodiment, and according to the invention, the first and second insertion protrusions 45a and 45b have different lengths from each other, and the insertion recesses 35 corresponding to the first and second insertion protrusions 45a and 45b have different lengths from each other. For example, as shown in FIG. 3, the first insertion protrusion 45a may have a first length LI, the second insertion protrusion 45b have a second length L2, and the first length L1 may be greater than the second length L2. One insertion recess of the insertion recesses 35, which corresponds to the first insertion protrusion 45a, has a relatively long length, and the other insertion recess of the insertion recesses 35, which corresponds to the second insertion protrusion 45b, has a relatively short length. Accordingly, a situation in which the first insertion protrusion 45a is inserted into the insertion recess having the length corresponding to the second insertion protrusion 45b or a situation in which the second insertion protrusion 45b is inserted into the insertion recess having the length corresponding to the first insertion protrusion 45a does not occur, and thus the first and second insertion protrusions 45a and 45b are inserted into corresponding insertion recesses, respectively.

In the exemplary embodiment of the present disclosure, and according to the claimed invention, the light emitted from the light emitting device 20 has an anisotropy. In this case, the window 40 is required to be aligned such that the light is emitted in a predetermined direction. Directions of the first and second insertion protrusions 45a and 45b serve to align the window 40 so that the light is emitted in the predetermined direction in response to the anisotropy of the light. Accordingly, the window 40 may be coupled only in a predetermined direction without being rotated, and the window 40 may be accurately aligned in the opening 39.

In the exemplary embodiment of the present disclosure, when the plural windows 40 are used, the first protrusions 45a of different windows 40 disposed in the light emitting areas face, according to the invention, the same direction and the second protrusions 45b of different windows 40 disposed in the light emitting areas also face the same direction.

According to another light emitting device module of the present disclosure falling outside the invention as claimed, the first and second insertion protrusions 45a and 45b of the windows 40 may face different directions from each other, respectively.

In addition, according to the exemplary embodiment of the present disclosure falling outside the scope of the claimed invention, the light may travel isotropically by the light emitting device 20 and the window 40 instead of being anisotropically travelled. In this case, according to the present exemplary embodiment, since the window 40 may be accurately aligned with the opening 39 by the first and second insertion protrusions 45a and 45b, the light emitting device module may have a reliable structure.

In the exemplary embodiment of the present disclosure, the surfaces of the flat part 40b of the window 40 are not required to be completely flat. The upper or lower surface of the flat part 40b may be substantially parallel to the upper surface of the substrate 10, however as shown in figures, the upper or lower surface of the flat part 40b may be slant with respect to the upper surface of the substrate 10 in some areas. The window 40 may be easily coupled to the holder 30 through the above-mentioned modification, however they should not be limited thereto or thereby.

The window of the window unit having the above-described structure may be easily replaced by being attached or detached to or from the holder in the one direction.

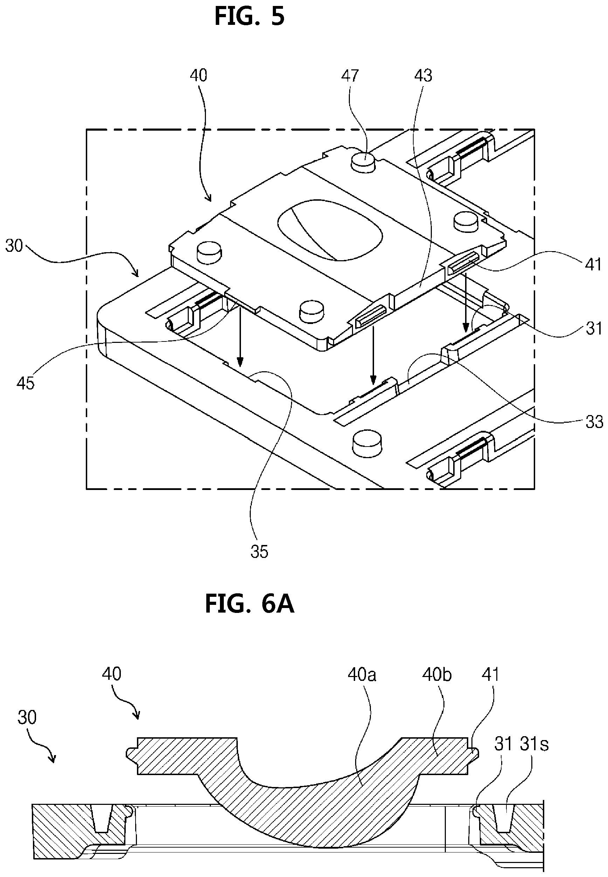

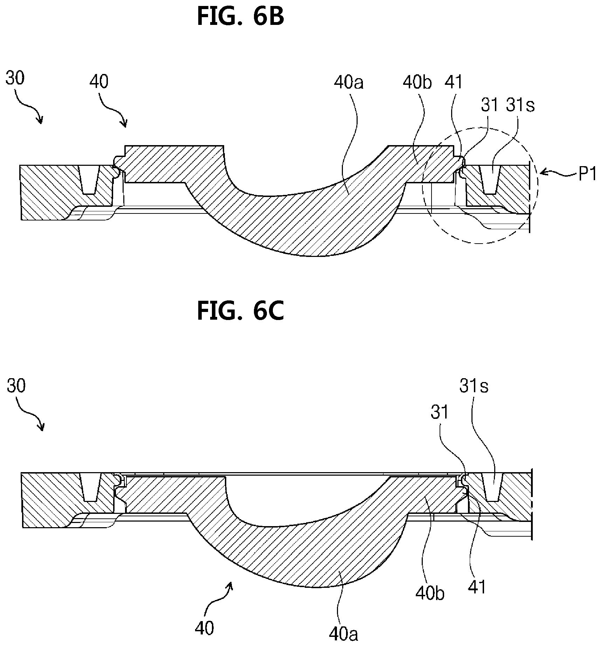

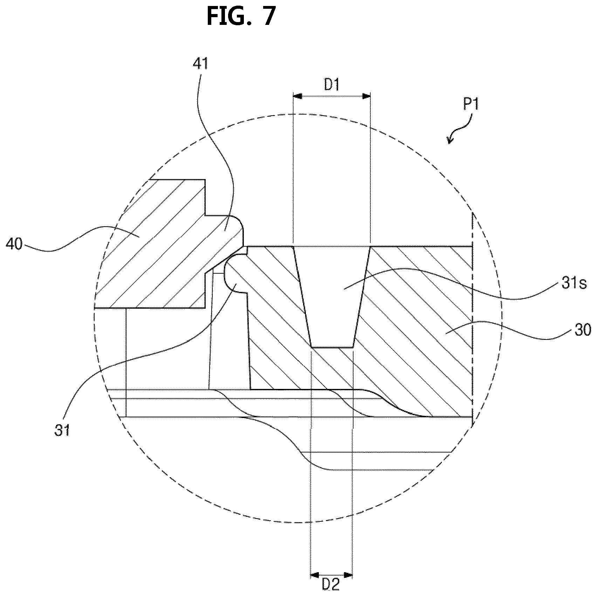

FIG. 5 is a perspective view showing a coupling process of the window 40 to the holder 30 in the window unit of the light emitting device module according to an exemplary embodiment of the present disclosure. FIGS. 6A, 6B, and 6C are cross-sectional views taken along a line B-B' to sequentially show processes for coupling the window 40 to the holder 30. FIG. 7 is an enlarged view showing a portion P1 of FIG. 6B.

As shown in FIGS. 5 and 6A, the window 40 may be inserted into and coupled to the holder 30 in a top-down manner, i.e., from top to bottom, or in a bottom-up manner, i.e., from bottom to top, depending on the direction of the coupling protrusions. In the exemplary embodiment of the present disclosure, the window 40 may be coupled to the holder 30 by applying the force to the window 40 from top to bottom after the window is upside down such that the convex portion of the window 40 faces the bottom.

The slot 31s is defined between an outer side surface of the holder 30 and the coupling protrusion to be adjacent to the coupling protrusion. The slot 31s provides the space to allow the coupling protrusion protruded from the holder 30 to move outwardly.

Then, as shown in FIGS. 5 and 6B, the holder coupling protrusion 31 and the window coupling protrusion 41 make contact with each other. The holder coupling protrusion 31 and the window coupling protrusion 41 are disposed at the position to overlap with each other when viewed in a plan view.

The holder coupling protrusion 31 and the window coupling protrusion 41 may have a curved shape in a cross-section. Accordingly, when the external force is applied to the bottom from the top, the holder coupling protrusion 31 slides backward. As a result, as shown in FIG. 6C, the window coupling protrusion 41 passes through the holder coupling protrusion 31 and is disposed beneath the holder coupling protrusion 31. In an exemplary embodiment, since the slot 31s is defined in one side portion of the holder coupling protrusion 31, the holder coupling protrusion 31 may easily move in an outward direction of the holder 30 and may be restored to its original position due to an elastic force after the window coupling protrusion 41 passes through the holder coupling protrusion 31 and is disposed beneath the holder coupling protrusion 31.

As shown in FIG. 7, the slot 31s has a width D1 at its upper portion and a width D2, which is different from the width D1, at its lower portion, and the width of the slot 31s becomes smaller as a distance from the upper surface of the holder 30 becomes larger. The difference in width of the slot 31s is provided to increase the rigidity of the holder coupling protrusion 31. When the width of the slot 31s is constant, the rigidity of the holder coupling protrusion 31 is weakened, and the restoration force of the holder coupling protrusion 31 may not be strong.

In the exemplary embodiment of the present disclosure, the window 40 is coupled to the holder 30 by the above-mentioned manner, and when a force is applied to an opposite direction to the above-mentioned direction, the window 40 may be separated from the holder 30.

The light emitting device module according to the exemplary embodiment of the present disclosure may be employed in various types of lighting devices. The light emitting device module may be, for example, an indoor light, such as an interior lamp, or an outdoor light, such as a street light.

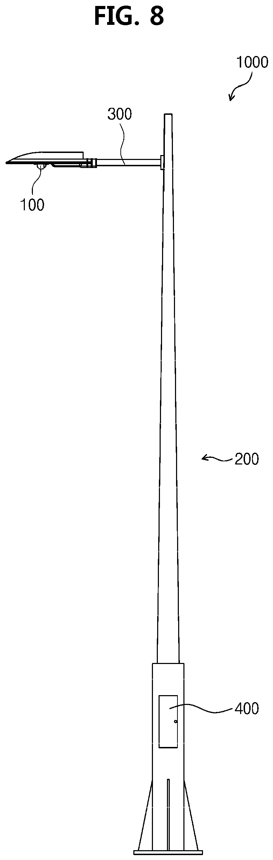

FIG. 8 is a side view showing the street light 1000 to which the light emitting device module is applied according to an exemplary embodiment of the present disclosure.

Referring to FIG. 8, the street light 1000 includes a pole 200 extending in one direction, an arm 300 connected to one side portion of the pole 200, and the light emitting device module 100.

The pole 200 has a bar shape extending upward from a ground. The pole 200 may be installed at various angles with respect to the ground and generally provided perpendicular to the ground.

The arm 300 is connected to an upper portion of the pole 200. The arm 300 has a bar shape extending in one direction. One end of the arm 300 is connected to the upper portion of the pole 200. The light emitting device module 100 is connected to the other end of the arm 300. The light emitting device module 100 may be provided with a cover that protects the light emitting device module 100 and allow the light emitted from the light emitting device module 100 to travel in downward and/or lateral direction.

In the present exemplary embodiment, the arm 300 extends from the pole 200 in one direction, however, this is merely exemplary. The arm 300 may have various shapes and may be omitted depending on the situation. In a case where the arm 300 is omitted, the light emitting device module 100 may be directly connected to the pole 200.

The light emitting device module 100 is connected to one end portion of the arm 300 to provide the light to the downward and/or lateral direction. The direction in which the light emitted from the light emitting device module 100 travels may be changed depending on a height of the street light 1000 and a position of the street light 1000.

In the exemplary embodiment of the present disclosure, a supporter that stably supports the pole 200 and a controller 400 that controls the light emitting device module 100 may be disposed at a lower portion of the pole 200. The controller 400 is electrically connected to the light emitting device module 100 and controls ON/OFF of the light emitting device of the light emitting device module 100 automatically or in response to a user's instructions.

The street light is described as the light emitting device module according to the exemplary embodiment of the present disclosure, however, the light emitting device module should not be limited to the street light. The light emitting device module may be applied to various devices in addition to the above-described embodiments.

Although the exemplary embodiments of the present disclosure have been described, it is understood that the present disclosure should not be limited to these exemplary embodiments but various changes and modifications can be made by one ordinary skilled in the art within the scope of the present disclosure as hereinafter claimed.

Therefore, the disclosed subject matter should not be limited to any single embodiment described herein, and the scope of the present inventive concept shall be determined according to the attached claims.

## Claims

1. A light emitting device module comprising:
a substrate (10) comprising a plurality of light emitting areas (11);
a light emitting device (20) disposed in each light emitting area (11) to emit a light;
windows (40) disposed on the substrate (10), each of the windows (40) covering each light emitting area (11) and having an asymmetrical shape with respect to a line (B-B') passing through the center of the window (40); and
a holder (30) to hold the windows (40), the holder (30) being provided with openings (39), each of which is defined therethrough in an asymmetrical shape corresponding to the each window (40) in the light emitting areas (11),
wherein each of the windows (40) is individually provided in a corresponding opening (39) among the openings (39) and detachably coupled to the holder (39),
wherein each of the window (40) and the holder (30) comprises an insertion member (35, 45) that determines a coupling direction when the each window (40) and the holder (30) are coupled to each other, and the insertion member (35, 45) has an asymmetrical shape with respect to the line (B-B') passing through the center of the window (40),
each window (40) further comprises an insertion protrusion (45) protruded toward the holder (30), and the holder (30) further comprises an insertion recess (35) into which the insertion protrusion (45) is inserted,
**characterized in that** the insertion protrusion (45) comprises a first insertion protrusion (45a) and a second insertion protrusion (45b), which are respectively disposed at both sides of the each window (40), and the first and second insertion protrusions (45a, 45b) have different lengths from each other, the insertion recess (35) comprises a first insertion recess (35a) and a second insertion recess (35b), the insertion recesses (35a, 35b) corresponding to the first and second insertion protrusions (45a, 45b) have different lengths from each other, and
wherein the light emitted from the light emitting device (20) has an anisotropy, and
protruding directions of the first and second insertion protrusions (45a, 45b) correspond to the anisotropy of the light, so as to align the window (40) such that the light is emitted in a predetermined direction in response to the anisotropy of the light, wherein the protruding directions of the first and second insertion protrusions (45a, 45b) of the window (40) disposed in each light emitting area (11) are same as each other.

2. The light emitting device module of claim 1, wherein the holder (30) comprises a holder coupling protrusion (31) protruded toward the each window (40), the each window (40) comprises a window coupling protrusion (41) protruded toward the holder (30), and the holder coupling protrusion (31) and the window coupling protrusion (41) are engaged with each other.

3. The light emitting device module of claim 2, wherein the holder (30) further comprises a slot (31s) recessed from a surface of the holder (30) and defined adjacent to the holder coupling protrusion (31), wherein the slot (31s) has a width that decreases as a distance from the surface increases.

4. The light emitting device module of claim 1, wherein the each window (40) further comprises a supporting protrusion (43) protruded toward the holder (30), and the holder (30) comprises a supporting recess (33) corresponding to the supporting protrusion (43) to stop movement of the window (40) in a predetermined direction beyond a certain distance.

5. The light emitting device module of claim 1, wherein the each window (40) comprises:
lens parts (40a) disposed to correspond to the light emitting area (11) and having a curved surface; and
a flat part (40b) disposed around the lens part (40a) and substantially parallel to a surface of the substrate (10).

6. The light emitting device module of claim 5, wherein the lens parts (40a) respectively disposed in the light emitting areas (11) have a same shape as each other; or wherein the lens parts (40a) respectively disposed in the light emitting (11) areas have different shapes from each other.

7. The light emitting device module of claim 6, wherein the each window (40) changes the light emitted from the light emitting device (20) in a predetermined direction.

8. The light emitting device module of claim 1, wherein a ratio of a width to a length of the holder (30) is about 1 : 0.8 to about 1 : 1.25, and a ratio of a width to a length of the window (40) is about 1 : 0.5 to about 1 : 1.3.

9. A street light comprising:
a pole (200) extending in one direction;
an arm (300) connected to one side portion of the pole (200); and
a light emitting device module according to claim 1 disposed at one end portion of the arm (300).

## Patentansprüche

1. Lichtemittierendes Vorrichtungsmodul, umfassend:
ein Substrat (10), das eine Vielzahl von lichtemittierenden Bereichen (11) umfasst;
eine lichtemittierende Vorrichtung (20), die in jedem lichtemittierenden Bereich (11) angeordnet ist, um Licht zu emittieren;
Fenster (40), die auf dem Substrat (10) angeordnet sind, wobei jedes der Fenster (40) jeden lichtemittierenden Bereich (11) bedeckt und eine asymmetrische Form in Bezug auf eine Linie (B-B'), die durch die Mitte des Fensters verläuft (40), aufweist; und
einen Halter (30), um die Fenster (40) zu halten, wobei der Halter (30) mit Öffnungen (39) versehen ist, von denen jeder dadurch in einer asymmetrischen Form definiert ist, die jedem Fenster (40) in den lichtemittierenden Bereichen (11) entspricht,
wobei jedes der Fenster (40) einzeln in einer entsprechenden Öffnung (39) unter den Öffnungen (39) vorgesehen und lösbar mit dem Halter (39) gekoppelt ist,
wobei sowohl das Fenster (40) als auch der Halter (30) ein Einführelement (35, 45) umfassen, das eine Kopplungsrichtung bestimmt, wenn jedes Fenster (40) und der Halter (30) miteinander verbunden sind, und das Einführelement (35, 45) eine asymmetrische Form in Bezug auf die Linie (B-B'), die durch die Mitte des Fensters (40) verläuft, aufweist,
wobei jedes Fenster (40) ferner einen Einführungsvorsprung (45) umfasst, der in Richtung des Halters (30) vorsteht, und der Halter (30) ferner eine Einführvertiefung (35) umfasst, in die der Einführungsvorsprung (45) eingeführt wird,
**dadurch gekennzeichnet, dass** der Einführungsvorsprung (45) einen ersten Einführungsvorsprung (45a) und einen zweiten Einführungsvorsprung (45b) umfasst, die jeweils an beiden Seiten jedes Fensters (40) angeordnet sind, und der erste und der zweite Einführungsvorsprüngen (45a,45b), voneinander unterschiedliche Längen aufweisen, wobei die Einführvertiefung (35) eine erste Einführvertiefung (35a) und eine zweite Einführvertiefung (35b) umfasst, wobei die Einführvertiefungen (35a, 36b), die den ersten und zweiten Einführungsvorsprüngen (45a, 45b) entsprechen, voneinander unterschiedliche Längen haben, und
wobei das von der lichtemittierenden Vorrichtung (20) emittierte Licht eine Anisotropie aufweist, und vorstehende Richtungen der ersten und zweiten Einführungsvorsprünge (45a, 45b) der Anisotropie des Lichts entsprechen, um das Fenster (40) derart auszurichten, das Licht in Reaktion auf die Anisotropie des Lichts in eine vorbestimmte Richtung emittiert wird,
wobei die Vorstehrichtungen der ersten und zweiten Einführungsvorsprünge (45a, 45b) des Fensters (40), die in jedem Lichtemissionsbereich (11) angeordnet sind, einander gleich sind.

2. Lichtemittierendes Vorrichtungsmodul nach Anspruch 1, wobei der Halter (30) einen Halterkopplungsvorsprung (31) umfasst, der zu jedem Fenster (40) vorsteht, wobei jedes Fenster (40) einen Fensterkopplungsvorsprung (41) umfasst, der in Richtung des Halters (30) vorsteht, und der Halterkopplungsvorsprung (31) und der Fensterkopplungsvorsprung (41) miteinander in Eingriff stehen.

3. Lichtemittierendes Vorrichtungsmodul nach Anspruch 2, wobei der Halter (30) ferner einen Schlitz (31s) umfasst, der von einer Oberfläche des Halters (30) ausgespart ist und angrenzend an den Halterkopplungsvorsprung (31) definiert ist, wobei der Schlitz (31s) eine Breite aufweist, die mit zunehmendem Abstand von der Oberfläche abnimmt.

4. Lichtemittierendes Vorrichtungsmodul nach Anspruch 1, wobei jedes Fenster (40) ferner einen Stützvorsprung (43) umfasst, der in Richtung des Halters (30) vorsteht, und der Halter (30) eine Stützvertiefung (33) umfasst, die dem Stützvorsprung (43) entspricht, um die Bewegung des Fensters (40) in einer vorbestimmten Richtung über einen bestimmten Abstand hinaus zu stoppen.

5. Lichtemittierendes Vorrichtungsmodul nach Anspruch 1, wobei jedes Fenster (40) umfasst:
Linsenteile (40a), die so angeordnet sind, dass sie dem Lichtemissionsbereich (11) entsprechen und eine gekrümmte Oberfläche aufweisen; und
einen flachen Teil (40b), der um den Linsenteil (40a) und im Wesentlichen parallel zu einer Oberfläche des Substrats (10) angeordnet ist.

6. Lichtemittierendes Vorrichtungsmodul nach Anspruch 5, wobei die Linsenteile (40a), die jeweils in den lichtemittierenden Bereichen (11) angeordnet sind, untereinander die gleiche Form aufweisen; oder
wobei die Linsenteile (40a), die jeweils in den lichtemittierenden (11) Bereichen angeordnet sind, voneinander unterschiedliche Formen aufweisen.

7. Lichtemittierendes Vorrichtungsmodul nach Anspruch 6, wobei jedes Fenster (40) das von der Lichtemissionsvorrichtung (20) emittierte Licht in einer vorbestimmten Richtung ändert.

8. Lichtemittierendes Vorrichtungsmodul nach Anspruch 1, wobei ein Verhältnis einer Breite zu einer Länge des Halters (30) etwa 1 : 0,8 bis etwa 1 : 1,25 beträgt und ein Verhältnis einer Breite zu einer Länge des Fensters (40) etwa 1 : 0,5 bis etwa 1 : 1,3 beträgt.

9. Straßenlampe umfassend:
einen Pfosten (200), der sich in eine Richtung erstreckt;
einen Arm (300), der mit einem Seitenabschnitt des Pfostens (200) verbunden ist; und
ein lichtemittierendes Vorrichtungsmodul nach Anspruch 1, das an einem Endabschnitt des Arms (300) angeordnet ist.

## Revendications

1. Module de dispositif d'émission de lumière comprenant :
un substrat (10) comprenant une pluralité de zones d'émission de lumière (11) ;
un dispositif d'émission de lumière (20) disposé dans chaque zone d'émission de lumière (11) pour émettre une lumière ;
des fenêtres (40) disposées sur le substrat (10), chacune des fenêtres (40) couvrant chaque zone d'émission de lumière (11) et ayant une forme asymétrique par rapport à une ligne (B-B') passant par le centre de la fenêtre (40) ; et
un support (30) pour maintenir les fenêtres (40), le support (30) étant pourvu d'ouvertures (39), chacune desquelles est définie à travers celui-ci dans une forme asymétrique correspondant à chaque fenêtre (40) dans les zones d'émission de lumière (11),
dans lequel chacune des fenêtres (40) est fournie individuellement dans une ouverture correspondante (39) parmi les ouvertures (39) et couplée de manière détachable au support (39),
dans lequel chacun de la fenêtre (40) et du support (30) comprend un élément d'insertion (35, 45) qui détermine une direction de couplage lorsque chaque fenêtre (40) et le support (30) sont couplés l'un à l'autre, et l'élément d'insertion (35, 45) a une forme asymétrique par rapport à la ligne (B-B') passant par le centre de la fenêtre (40),
chaque fenêtre (40) comprend en outre une saillie d'insertion (45) faisant saillie vers le support (30), et le support (30) comprend en outre un évidement d'insertion (35) dans lequel la saillie d'insertion (45) est insérée,
**caractérisé en ce que** la saillie d'insertion (45) comprend une première saillie d'insertion (45a) et une deuxième saillie d'insertion (45b), qui sont respectivement disposées des deux côtés de chaque fenêtre (40), et les première et seconde saillies d'insertion (45a, 45b) ont des longueurs différentes l'une de l'autre, l'évidement d'insertion (35) comprend un premier évidement d'insertion (35a) et un deuxième évidement d'insertion (35b), les évidements d'insertion (35a, 35b) correspondant aux première et deuxième saillies d'insertion (45a, 45b) ont des longueurs différentes l'un de l'autre, et
dans lequel la lumière émise par le dispositif d'émission de lumière (20) présente une anisotropie, et des directions de saillie des première et deuxième saillies d'insertion (45a, 45b) correspondent à l'anisotropie de la lumière, de manière à aligner la fenêtre (40) de telle sorte que la lumière soit émise dans une direction prédéterminée en réponse à l'anisotropie de la lumière,
dans lequel les directions de saillie des première et deuxième saillies d'insertion (45a, 45b) de la fenêtre (40) disposées dans chaque zone d'émission de lumière (11) sont identiques l'une à l'autre.

2. Module de dispositif d'émission de lumière de la revendication 1, dans lequel le support (30) comprend une saillie de couplage de support (31) faisant saillie vers chaque fenêtre (40), chaque fenêtre (40) comprend une saillie de couplage de fenêtre (41) faisant saillie vers le support (30), et la saillie de couplage de support (31) et la saillie de couplage de fenêtre (41) sont engagées l'une avec l'autre.

3. Module de dispositif d'émission de lumière de la revendication 2, dans lequel le support (30) comprend en outre une fente (31s) en retrait par rapport à une surface du support (30) et définie adjacente à la saillie de couplage de support (31), dans lequel la fente (31s) a une largeur qui diminue à mesure qu'une distance de la surface augmente.

4. Module de dispositif d'émission de lumière de la revendication 1, dans lequel chaque fenêtre (40) comprend en outre une saillie de soutien (43) faisant saillie vers le support (30), et le support (30) comprend un évidement de soutien (33) correspondant à la saillie de soutien (43) pour arrêter le mouvement de la fenêtre (40) dans une direction prédéterminée au-delà d'une certaine distance.

5. Module de dispositif d'émission de lumière de la revendication 1, dans lequel chaque fenêtre (40) comprend :
des parties de lentille (40a) disposées pour correspondre à la zone d'émission de lumière (11) et
ayant une surface incurvée ; et
une partie plate (40b) disposée autour de la partie de lentille (40a) et sensiblement parallèle à une surface du substrat (10).

6. Module de dispositif d'émission de lumière de la revendication 5, dans lequel les parties de lentille (40a) disposées respectivement dans les zones d'émission de lumière (11) ont la même forme les unes que les autres ; ou
dans lequel les parties de lentille (40a) disposées respectivement dans les zones d'émission de lumière (11) ont des formes différentes les unes des autres.

7. Module de dispositif d'émission de lumière de la revendication 6, dans lequel chaque fenêtre (40) modifie la lumière émise par le dispositif d'émission de lumière (20) dans une direction prédéterminée.

8. Module de dispositif d'émission de lumière de la revendication 1, dans lequel un rapport entre une largeur et une longueur du support (30) est d'environ 1 : 0,8 à environ 1 : 1,25, et un rapport entre une largeur et une longueur de la fenêtre (40) est d'environ 1 : 0,5 à environ 1 : 1,3.

9. Réverbère comprenant :
un poteau (200) s'étendant dans une direction ;
un bras (300) relié à une portion latérale du poteau (200) ; et
un module de dispositif d'émission de lumière selon la revendication 1 disposé au niveau d'une portion d'extrémité du bras (300).
